# FASCICULE DE BREVET EUROPEEN

(11) **EP 1 762 854 B1**
(45) Date de publication et mention de la délivrance du brevet: **24.12.2014**
(21) Numéro de dépôt: 06120041.6
(22) Date de dépôt: 04.09.2006
(51) Int. Cl.: G01R 19/00, G01T 1/17

(54) **Dispositif de mesure d'impulsions de courant très brèves**
Messvorrichtung für sehr kurze Strompulse
Measuring device for very short current impulses

(30) Priorité: 09.09.2005 FR 0509223
(43) Date de publication de la demande: 14.03.2007
(73) Titulaire: Commissariat à l'Énergie Atomique et aux Énergies Alternatives, 75015 Paris (FR)
(72) Inventeur: Ouvrier-Buffet, Patrice, 74410 Saint Jorioz-France (FR); Rostaing, Jean-Pierre, 38260 La Côte Saint André (FR)
(74) Mandataire: Guérin, Michel

(56) Documents cités:
- WO-A-2004/051314
- US-B1- 6 211 664

## Description

L'invention concerne la mesure d'impulsions de courant très brèves (quelques nanosecondes) et d'amplitude très faible (quelques microampères), telles que celles qui peuvent émaner d'un photodétecteur utilisé pour de la transmission optique de données à très haut débit, ou d'un photodétecteur (photodiode ou photoconducteur) soumis à un rayonnement de nature impulsionnelle (notamment : rayonnements X, gamma, etc.).

Par mesure d'impulsions, on entend ici de manière générale soit la simple détection de présence d'impulsions (par exemple pour la transmission numérique de données) soit la mesure de caractéristiques de ces impulsions (amplitude, durée principalement).

Les impulsions à mesurer sont en général appliquées à une chaîne de détection comprenant principalement un amplificateur appelé amplificateur "transimpédance".

Un amplificateur transimpédance a pour fonction essentielle de convertir un courant d'entrée lin en une tension de sortie Vout, avec une fonction de transfert du type Vout/lin = -R1/(1+R1.C1.s) où s est la variable d'échantillonnage ou la variable de Laplace c'est-à-dire une variable représentant une fréquence ou une composante de fréquence du courant d'entrée variable, R1 la valeur d'une résistance et C1 la valeur d'une capacité. Un amplificateur transimpédance est classiquement constitué par un amplificateur à grand gain ayant pour contre-réaction, entre sa sortie et son entrée, une résistance de valeur R1 en parallèle avec une capacité de valeur C1.

La fonction de transfert d'un tel amplificateur transimpédance est une fonction de la fréquence, par l'intermédiaire de la variable s. La fréquence de coupure pour laquelle la tension de sortie perd trois décibels par rapport à ce qu'elle serait à basse fréquence est Fc = 1/(2πR1.C1).

Le gain de transimpédance, c'est-à-dire l'amplitude de la tension obtenue pour une amplitude de courant d'entrée donnée, est fixé par la valeur de R1, valeur qui intervient aussi dans la fréquence de coupure. Le rapport signal/bruit augmente avec la valeur de R1 mais la bande passante est alors réduite d'autant. Ce montage ne permet donc pas d'avoir à la fois une grande bande passante et un bon rapport signal sur bruit.

La capacité C1 est indispensable au bon fonctionnement de l'amplificateur car elle assure la stabilité du montage. Elle est choisie en fonction du gain désiré et de la fréquence d'utilisation souhaitée, et elle est aussi choisie en fonction de la capacité d'entrée de l'amplificateur transimpédance (assimilable à une capacité parasite) et en fonction de la valeur absolue G du gain propre de l'amplificateur à grand gain qui forme le coeur de l'amplificateur transimpédance.

Dans une chaîne de détection d'impulsions de courant, l'amplificateur transimpédance peut être suivi d'un amplificateur de tension qui permet d'obtenir un niveau de tension suffisant en sortie si l'amplificateur transimpédance ne fournit pas directement un niveau suffisant.

Le document WO 2004/051314 A décrit un circuit de traitement amélioré pour chaîne de spectrométrie.

L'invention a pour but de proposer un circuit de détection d'impulsions qui permet d'optimiser le compromis entre les caractéristiques de bande passante et rapport signal/bruit de la chaîne de détection.

Pour y parvenir, l'invention propose un circuit de mesure d'impulsions de courant brèves comportant :
- un étage intégrateur comprenant un premier amplificateur à grand gain dont la sortie est rebouclée sur l'entrée par l'intermédiaire d'une résistance de valeur Rp et d'une capacité de valeur Cint ;
- un étage dérivateur comprenant un deuxième amplificateur à grand gain, une capacité d'entrée de valeur C2 en série entre la sortie de l'étage intégrateur et l'entrée du deuxième amplificateur à grand gain, le deuxième amplificateur ayant sa sortie rebouclée sur son entrée par l'intermédiaire d'une résistance de valeur R2 ;
- un étage soustracteur recevant sur une première entrée la sortie de l'étage intégrateur et sur une deuxième entrée la sortie de l'étage dérivateur et fournissant sur sa sortie la différence entre les tensions sur ses deux entrées.

De préférence, pour un fonctionnement optimal du circuit, on choisit les valeurs de résistances et de capacités de telle sorte que le produit R2.C2 soit aussi proche que possible du produit Rp.Cint.

On choisit par ailleurs la valeur du produit Rp.Cint suffisamment élevée pour que l'étage intégrateur se comporte bien en intégrateur aux fréquences de travail envisagées (en particulier à la fréquence de renouvellement des impulsions de courant d'entrée lorsque celles-ci sont périodiques). Pour cela, on choisit le produit Rp.Cint plus élevé que l'inverse de la fréquence de travail minimale à laquelle on veut que le circuit de détection fonctionne correctement.

D'autres caractéristiques et avantages de l'invention apparaîtront à la lecture de la description détaillée qui suit et qui est faite en référence aux dessins annexés dans lesquels :
- la figure 1 représente un circuit de mesure à amplificateur de transimpédance ;
- la figure 2 représente la structure de circuit de mesure selon l'invention ;
- la figure 3 représente les tensions à l'entrée et à la sortie des différents étages du circuit de la figure 2 dans un exemple d'application.

Dans ce qui suit, on désignera par la même lettre (R1 par exemple) à la fois un élément de circuit (une résistance par exemple) et la valeur numérique caractéristique de cet élément (la valeur de la résistance par exemple).

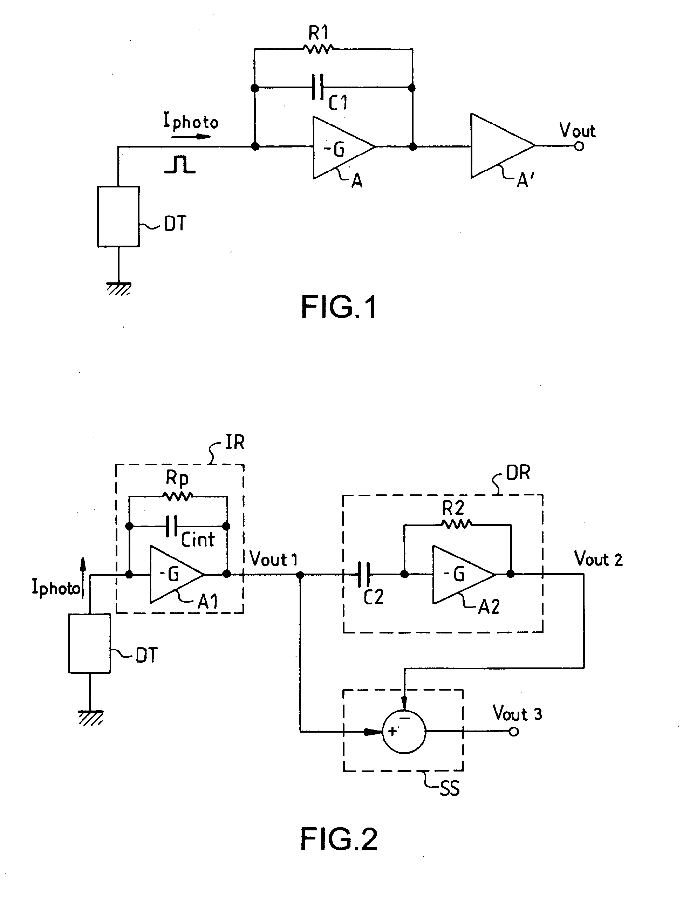

Sur la figure 1, on rappelle d'abord le principe connu d'une chaîne de détection d'impulsions de courant utilisant un amplificateur de type transimpédance.

Le courant à mesurer est par exemple un courant Iphoto issu d'un détecteur de rayonnement DT recevant un rayonnement de type impulsionnel (par exemple un détecteur de rayons X ou gamma) et fournissant des impulsions de courant brèves (quelques nanosecondes) et de faible amplitude (quelques microampères).

Le courant Iphoto est appliqué à l'entrée d'un amplificateur à grand gain (gain -G) désigné par A, à grande impédance d'entrée, et à faible impédance de sortie (amplificateur opérationnel).

Le détecteur peut être considéré comme étant une source de courant parfaite de valeur Iphoto. On pourrait aussi considérer qu'il possède une impédance interne sous forme d'une résistance et une capacité, mais pour la suite des explications on considérera que la valeur de cette impédance interne est négligeable et que la totalité du courant Iphoto est intégralement appliquée à l'entrée de l'amplificateur A.

L'amplificateur opérationnel A a sa sortie rebouclée sur son entrée par l'intermédiaire d'une résistance R1 et d'une capacité C1. Cet amplificateur ainsi rebouclé fonctionne en amplificateur de transimpédance à la condition que la fréquence de travail soit largement inférieure à la fréquence de coupure Fc = 1/(2πR1.C1). Cela veut dire qu'il faut une fréquence de coupure très élevée si on veut travailler avec des impulsions brèves. Par conséquent la résistance et la capacité doivent être de faible valeur dans ce montage de l'art antérieur. R1 étant de faible valeur la tension de sortie est alors faible. Il est en général nécessaire de faire suivre cet amplificateur de transimpédance d'un amplificateur de tension A' de fort gain.

La tension de sortie Vout d'un tel circuit de mesure est alors Vout = -k.R1.lphoto si k est le gain de l'amplificateur A', ceci à condition qu'on travaille bien en dessous de la fréquence de coupure. Au delà, la tension de sortie n'est plus représentative du courant d'entrée.

Ce montage n'offre pas de bon compromis entre la bande passante et le rapport signal/bruit obtenu.

La figure 2 représente le principe de l'invention qui vise à améliorer ce compromis. Le circuit de détection comporte trois étages :
- un étage intégrateur IR dont la constitution est très semblable à celle d'un amplificateur transimpédance mais qui utilise des valeurs numériques très différentes pour les résistances et capacités car il est utilisé au-dessus de sa fréquence de coupure contrairement à un amplificateur transimpédance d'une chaîne de détection de l'art antérieur ;
- un étage dérivateur DR dont l'entrée reçoit la sortie de l'étage intégrateur ;
- un étage soustracteur SS qui reçoit les sorties des deux étages précédents et qui fournit une tension égale à la différence des tensions présentes sur ces deux sorties.

Le courant d'entrée à mesurer est ici encore un courant désigné par Iphoto, qui est par exemple issu d'un photodétecteur fournissant un courant de type impulsionnel.

Le photodétecteur est supposé encore avoir une impédance interne négligeable et peut être considéré comme étant une source de courant parfaite de valeur Iphoto. Cela signifie que le courant Iphoto est appliqué pratiquement en totalité à l'entrée de l'étage intégrateur IR.

Le détecteur nécessite parfois pour son fonctionnement une source de polarisation continue ; cette source n'est pas représentée pour ne pas alourdir le schéma.

L'étage intégrateur IR comporte un amplificateur A1 à grand gain intrinsèque (valeur -G) dont l'entrée reçoit le courant Iphoto, c'est-à-dire que le détecteur est directement connecté à l'entrée de l'amplificateur A1. L'amplificateur a par ailleurs une grande impédance d'entrée et une faible impédance de sortie. L'amplificateur A1 a sa sortie rebouclée sur son entrée par l'intermédiaire d'une résistance Rp en parallèle avec une capacité Cint.

La fréquence de coupure au delà de laquelle ce montage ne fournit plus vraiment une tension proportionnelle au courant Iphoto mais une tension réduite d'au moins 3 décibels par rapport à la tension obtenue pour le même courant à très basse fréquence est égale à 1/(2πRp.Cint), et on choisit la valeur de Rp.Cint telle que si la fréquence minimale à laquelle on veut travailler est Fm, alors le produit Rp.Cint est supérieur à 1/2πFm. En d'autres mots, on utilise comme étage intégrateur un étage analogue à un amplificateur transimpédance, mais que l'on fait fonctionner au delà de sa fréquence de coupure de sorte qu'il n'est plus un amplificateur transimpédance.

Cet étage intégrateur IR fournit alors une tension de sortie Vout1 égale à -Rp.Iphoto/(1+ s.Rp.Cint) où s est la variable d'échantillonnage, ou bien la variable de Laplace, représentant la fréquence de travail.

L'étage dérivateur DR reçoit cette tension de sortie Vout1. Il comporte principalement un autre amplificateur A2 à grand gain intrinsèque, grande impédance d'entrée et faible impédance de sortie, une capacité d'entrée en série, C2, et une résistance de rebouclage R2. Le gain intrinsèque de l'amplificateur A2 est une valeur -G qui peut être égale ou non à celle de l'amplificateur A1.

La capacité d'entrée C2 est reliée entre la sortie de l'étage intégrateur IR et l'entrée de l'amplificateur A2. La résistance de rebouclage R2 est connectée entre la sortie de l'amplificateur A2, qui est également la sortie de l'étage dérivateur, et l'entrée de l'amplificateur A2. La tension présente sur la sortie de l'étage dérivateur est désignée par Vout2.

La fonction de transfert de cet étage dérivateur est Vout2/Vout1 = -R2.C2.s, qui est bien une fonction de dérivation.

L'étage soustracteur (SS) possède deux entrées dont l'une reçoit la tension de sortie Vout1 de l'étage intégrateur et l'autre reçoit la tension de sortie Vout2 de l'étage dérivateur. Il fournit une tension Vout1-Vout2 ou Vout2-Vout1.

La sortie du circuit de mesure de courant est la sortie de l'étage soustracteur SS. La fonction de transfert globale est égale à (Vout1-Vout2)/Iphoto. Elle est donc égale à (Vout1+Vout1.R2.C2.s)/Iphoto, ou encore (1+s.R2.C2)(-Rp)/(1+s.Rp.Cint)

On choisit de préférence le produit R2.C2 aussi proche que possible du produit Rp.Cint, et si possible on réalise l'égalité entre ces produits. La fonction de transfert globale Vout/Iphoto devient égale à -Rp, c'est-à-dire que c'est une fonction de transimpédance, mais avec une valeur de Rp qui peut être significativement supérieure à celle qui était obtenue avec un simple amplificateur de transimpédance classique.

Il en résulte qu'on peut fonctionner avec un excellent compromis bande passante rapport signal/bruit.

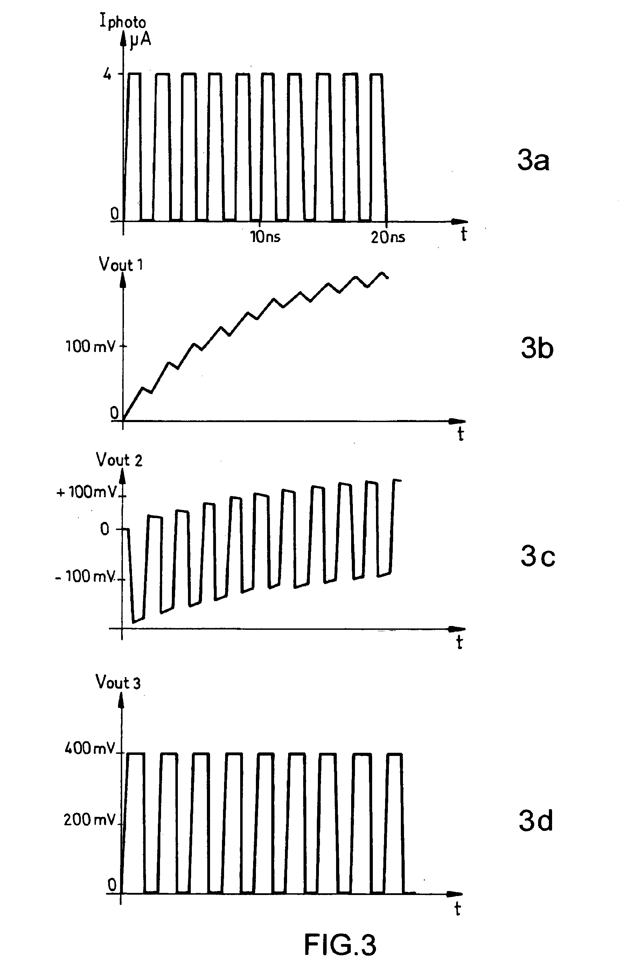

Les figures 3a, 3b, 3c, et 3d représentent à titre d'illustration respectivement l'allure d'un courant impulsionnel Iphoto issu d'un photodétecteur, l'allure de la tension Vout1 en sortie de l'étage intégrateur, l'allure de la tension Vout 2 en sortie de l'étage dérivateur, et l'allure de la tension de sortie Vout3 de l'étage soustracteur.

Ces courbes sont données à titre d'exemple en utilisant les valeurs numériques suivantes : Rp = 100 kiloohms, Cint = 0,1 pF, R2 = 1 kiloohm, C2 = 10 pF. Le courant impulsionnel est une suite de créneaux de 4000 nanoampères de largeur 1 nanoseconde et de période 2 nanosecondes.

Les simulations effectuées montrent que la fréquence de coupure du circuit de mesure selon l'invention peut être dix fois supérieure à la fréquence de coupure d'un circuit à amplificateur transimpédance, et que la tension de bruit total en sortie peut être trois fois plus faible.

Ces performances peuvent être réduites si on tient compte de l'imperfection des amplificateurs opérationnels, de la présence de capacités ou résistances parasites, ou de l'imprécision de l'appariement des produits Rp.Cint et R2.C2, mais elles restent de toutes façons avantageuses.

La structure du circuit de mesure selon l'invention est différentielle : le signal est issu de la différence entre une intégrale et une dérivée, ce qui a un effet compensatoire sur les décalages de tension (offsets) inévitables dans les circuits et sur la dérive de ces décalages en fonction du temps ou de la température. L'effet des bruits d'alimentation ou des perturbations électromagnétiques est également réduit du fait de ce fonctionnement par différence.

## Revendications

1. Circuit de mesure d'impulsions de courant brèves, comportant :
- un étage intégrateur (IR) comprenant un premier amplificateur à grand gain (A1) dont la sortie est rebouclée sur l'entrée par l'intermédiaire d'une résistance de valeur Rp en paralléle avec une capacité de valeur Cint ;
- un étage dérivateur (DR) comprenant un deuxième amplificateur à grand gain (A2), une capacité d'entrée de valeur C2 en série entre la sortie de l'étage intégrateur et l'entrée du deuxième amplificateur (A2), le deuxième amplificateur ayant sa sortie rebouclée sur son entrée par l'intermédiaire d'une résistance de valeur R2 ;
- un étage soustracteur (SS) recevant sur une première entrée la sortie de l'étage intégrateur (IR) et sur une deuxième entrée la sortie de l'étage dérivateur (DR) et fournissant sur sa sortie la différence entre les tensions sur ses deux entrées.

2. Circuit de mesure selon la revendication 1, **caractérisé en ce que** le produit R2.C2 est aussi proche que possible du produit Rp.Cint.

3. Circuit de mesure selon l'une des revendications 1 et 2, **caractérisé en ce que** le produit Rp.Cint est plus élevé que l'inverse de la fréquence de travail minimale à laquelle on veut que le circuit de détection fonctionne correctement.

## Patentansprüche

1. Messschaltung für kurze Stromimpulse, die Folgendes umfasst:
- eine Integratorstufe (IR), die einen ersten Verstärker mit großer Verstärkung (A1) umfasst, dessen Ausgang mittels eines Widerstands mit einem Wert Rp parallel zu einem Kapazitätsglied mit dem Wert Cint zum Eingang zurückgeführt ist;
- eine Differenzierstufe (DR), die einen zweiten Verstärker mit großer Verstärkung (A2), ein Eingangskapazitätsglied mit dem Wert C2 in Serie zwischen dem Ausgang der Integratorstufe und dem Eingang des zweiten Verstärkers (A2) umfasst, wobei der Ausgang des zweiten Verstärkers mittels eines Widerstands mit dem Wert R2 zu seinem Eingang zurückgeführt ist;
- eine Subtrahierstufe (SS), die an einem ersten Eingang den Ausgang der Integratorstufe (IR) empfängt und auf einem zweiten Eingang den Ausgang der Differenzierstufe (DR) empfängt und die Differenz zwischen den Spannungen an ihren beiden Eingängen an ihrem Ausgang auslegt.

2. Messschaltung nach Anspruch 1, **dadurch gekennzeichnet, dass** das Produkt von R2 x C2 auch möglichst nahe an dem Produkt von Rp x Cint liegt.

3. Messschaltung nach einem der Ansprüche 1 und 2, **dadurch gekennzeichnet, dass** das Produkt von Rp x Cint höher ist als die Umkehr der minimalen Arbeitsfrequenz, auf der die Erkennungsschaltung korrekt arbeiten soll.

## Claims

1. Circuit for measuring brief current pulses, comprising:
- an integrator stage (IR) comprising a first high-gain amplifier (A1), the output of which is looped back to the input via a resistor of value Rp in parallel with a capacitor of value Cint;
- a differentiator stage (DR) comprising a second high-gain amplifier (A2), an input capacitor of value C2 in series between the output of the integrator stage and the input of the second amplifier (A2), the second amplifier having its output looped back to its input via a resistor of value R2;
- a subtractor stage (SS) receiving on a first input the output from the integrator stage (IR) and on a second input the output from the differentiator stage (DR) and supplying on its output the difference between the voltages on its two inputs.

2. Measurement circuit according to Claim 1, **characterized in that** the product R2.C2 is as close as possible to the product Rp.Cint.

3. Measurement circuit according to one of Claims 1 and 2, **characterized in that** the product Rp.Cint is higher than the inverse of the minimum working frequency at which the detection circuit is desired to operate correctly.
